# EUROPEAN PATENT APPLICATION

(11) **EP 4 768 686 A1**
(43) Date of publication of application: **01.07.2026**
(21) Application number: 24864065.8
(22) Date of filing: 25.04.2024
(51) Int. Cl.: E05C 17/02

(54) **LIMITING MECHANISM AND ENERGY STORAGE DEVICE**

(30) Priority: 13.09.2023 CN 202322483169 U
(71) Applicant: Contemporary Amperex Technology Co., Limited, Ningde, Fujian 352100 (CN)
(72) Inventor: ZHANG, Mingliang, Ningde, Fujian 352100 (CN); SU, Haibin, Ningde, Fujian 352100 (CN); PENG, Haoran, Ningde, Fujian 352100 (CN)
(74) Representative: Gong, Jinping
(86) International application number: PCT/CN2024/089808
(87) International publication number: WO 2025/055340

(57) **Abstract**

The present application discloses a limiting mechanism (100) and an energy storage device. The limiting mechanism (100) comprises: a connecting seat (10) provided with a guide structure (1101), wherein the guide structure (1101) is arranged in the length direction of the connecting seat (10); a connecting shaft (20) in sliding fit with the guide structure (1101); and a connecting arm (30) connected to the connecting shaft (20). A locking position (1102) for locking the position of the connecting shaft (20) in the length direction of the connecting seat (10) is further provided on the connecting seat (10). When the connecting arm (30) and the connecting seat (10) are unfolded, the connecting shaft (20) can slide along the guide structure (1101) to adapt to the unfolding angle between the connecting arm (30) and the connecting seat (10), and when the connecting shaft (20) slides to the locking position (1102), the locking position (1102) can lock the position of the connecting shaft (20), so that the position of the connecting shaft (20) is kept stable, and the unfolding angle between the connecting arm (30) and the connecting seat (10) is locked, thereby locking the opening degree of a door (300).

## Description

### CROSS-REFERENCE

The present application claims priority to Chinese Patent Application No. 202322483169.4 filed with China National Intellectual Property Administration on September 13, 2023 and entitled "LIMITING MECHANISM AND ENERGY STORAGE DEVICE", which is incorporated herein by reference in its entirety.

### TECHNICAL FIELD

The present application relates to the technical field of energy storage devices, and in particular, to a limiting mechanism and an energy storage device.

### BACKGROUND

In the related art, an electrical cabinet includes a case and a door hinged to the case. In order to control the opening range of the door during the process when a worker opens the electrical cabinet for operation, the door and the case are usually connected by using a limiting mechanism, so as to limit the opening degree of the door. When the worker opens the door for operation, the limiting structure cannot lock the position of the door, such that the door is prone to movement due to external forces, which is not conducive to the worker's operation.

### SUMMARY

In view of the above problems, an objective of embodiments of the present application is to provide a limiting mechanism and an energy storage device, which can ameliorate the technical problem that the limiting structure cannot lock the position of a door.

The technical solutions used in the embodiments of the present application are as follows.

In a first aspect, the embodiments of the present application provide a limiting mechanism, including:
a connecting seat, where the connecting seat is provided with a guide structure, and the guide structure is arranged in a length direction of the connecting seat;
a connecting shaft in sliding fit with the guide structure; and
a connecting arm connected to the connecting shaft, where
the connecting seat is further provided with a locking position for locking a position of the connecting shaft in the length direction of the connecting seat.

With the connecting shaft in sliding fit with the guide structure, when the connecting arm is deployed from the connecting seat, the connecting shaft can slide along the guide structure to adapt to the angle of deployment of the connecting arm relative to the connecting seat. When the connecting shaft slides to the locking position, the locking position can lock the position of the connecting shaft, such that the position of the connecting shaft is kept stable, and the angle of deployment of the connecting arm relative to the connecting seat is locked, so as to lock the opening degree of a door and prevent changes in the opening degree of the door during operation.

In an embodiment, the guide structure is a strip-shaped hole.

With the technical means described above, the connecting shaft can be guided to slide in the length direction of the connecting seat, and the connecting shaft can be allowed to rotate in the strip-shaped hole, so as to automatically adapt to changes in the angle of deployment of the connecting arm relative to the connecting seat.

In an embodiment, the locking position is a limiting hole in communication with the strip-shaped hole, a diameter of the limiting hole being greater than a width of the strip-shaped hole.

The connecting shaft includes a first shaft section in sliding fit with the strip-shaped hole and a second shaft section connected to the first shaft section, the second shaft section being adapted to the limiting hole.

With the technical means described above, when the first shaft section slides to the limiting hole, the connecting shaft slides in the depth direction of the limiting hole until the second shaft section is limited in the limiting hole, and the limiting hole restricts the second shaft section from continuing to slide along the strip-shaped hole, such that the position of the connecting shaft in the length direction of the connecting seat is kept stable, and the angle of deployment of the connecting arm relative to the connecting seat is kept relatively stable. After the connecting shaft returns, the second shaft section exits the limiting hole, the first shaft section enters the limiting hole, and the first shaft section can slide into the strip-shaped hole again to facilitate the continuous adjustment of the position of the connecting shaft, thereby adjusting the angle of deployment of the connecting arm relative to the connecting seat.

In an embodiment, a third shaft section is provided at an end of the second shaft section distal to the first shaft section, a diameter of the third shaft section being greater than the diameter of the limiting hole.

With the technical means described above, when the connecting shaft slides until the second shaft section is limited in the limiting hole, since the diameter of the third shaft section is greater than the diameter of the limiting hole, it is possible to prevent the connecting shaft from sliding out of the limiting hole from the end of the second shaft section distal to the first shaft section, thereby preventing the connecting shaft from being separated from the connecting seat.

In an embodiment, an end of the first shaft section distal to the second shaft section is connected to the connecting arm.

With the technical means described above, it is possible to prevent the connecting shaft from sliding out of the limiting hole or the strip-shaped hole from the end of the first shaft section distal to the second shaft section, thereby preventing the connecting shaft from being separated from the connecting seat.

In an embodiment, a positioning disc for stopping and positioning the connecting arm is provided in a middle of the first shaft section in an axial direction, the connecting arm sleeves the first shaft section, and the connecting arm is located on a side of the positioning disc distal to the second shaft section.

With the technical means described above, it is possible to position the position of the connecting arm on the first shaft section, so as to control the distance between the connecting arm and the third shaft section and limit the extent to which the connecting shaft slides in the depth direction of the strip-shaped hole.

In an embodiment, the connecting seat includes a connecting plate, a first side plate disposed on a side of the connecting plate in a width direction, and a second side plate disposed on the other side of the connecting plate in the width direction, where the first side plate and the second side plate are located on a side of the connecting plate in a thickness direction, and the guide structure and the locking position are disposed on the connecting plate.

With the technical means described above, the anti-bending strength of the connecting seat can be enhanced to prevent the connecting seat from bending and deforming.

In an embodiment, the connecting seat further includes fixing members connecting the first side plate and the second side plate.

With the technical means described above, the distance between the first side plate and the second side plate can be kept stable, thereby enhancing the stability of the first side plate and the second side plate.

In an embodiment, a plurality of fixing members are provided, and the plurality of fixing members are arranged in a length direction of the connecting plate.

With the technical means described above, the stability of the first side plate and the second side plate can be improved, and the structural strength of the connecting seat can be enhanced.

In an embodiment, fasteners are mounted on the first side plate for connection to a case.

With the technical means described above, the first side plate can be easily connected and fixed to the door.

In an embodiment, the connecting arm is located on the other side of the connecting plate in the thickness direction.

With the technical means described above, it is possible to avoid the first side plate and the second side plate interfering with the rotation of the connecting arm, and is conducive to reducing the spacing between the connecting arm and the connecting plate and the length of the connecting shaft, and improving the stability between the connecting arm and the connecting seat.

In an embodiment, the connecting arm is provided with a reinforcing rib, and the reinforcing rib is arranged in a length direction of the connecting arm.

With the technical means described above, the anti-bending strength of the connecting arm can be enhanced.

In an embodiment, the connecting arm includes a first plate section connected to the connecting shaft, a second plate section connected to an end of the first plate section distal to the connecting shaft, and a third plate section connected to an end of the second plate section distal to the first plate section, where the second plate section is obliquely arranged toward a direction away from the connecting seat from the end of the first plate section distal to the connecting shaft to an end of the third plate section proximal to the connecting shaft.

With the technical means described above, when the connecting arm is folded to the side edge of the connecting seat, the distance between an end of the connecting arm distal to the connecting shaft and the connecting seat can be increased, and collision between the end of the connecting arm distal to the connecting shaft and the connecting seat can be prevented when the door is closed.

In an embodiment, the reinforcing rib is located on a side of the third plate section proximal to the connecting seat, and the reinforcing rib is connected to the second plate section and the third plate section.

With the technical means described above, it is possible to increase the structural strength of the second plate section and the third plate section, thereby preventing the second plate section and the third plate section from bending and deforming.

In an embodiment, a height of the reinforcing rib gradually decreases from an end of the second plate section proximal to the first plate section to an end of the third plate section distal to the first plate section.

With the technical means described above, it is condutive to reducing friction between the reinforcing rib and the connecting plate when the connecting arm rotates relative to the connecting seat, and is condutive to the demolding of the connecting arm during casting.

In an embodiment, each side surface of the reinforcing rib in a width direction is inclined toward a direction close to a middle of the reinforcing rib in the width direction from a side of the reinforcing rib proximal to the third plate section to a side of the reinforcing rib distal to the first plate section.

With the technical means described above, a certain draft angle is formed between two side surfaces of the reinforcing rib in the width direction, which facilitates demolding during casting.

In an embodiment, a rotating shaft for being hinged to a case is mounted at an end of the connecting arm distal to the connecting shaft.

With the technical means described above, the connecting arm can be easily hinged to the door.

In an embodiment, a shaft sleeve sleeves the rotating shaft, and the connecting arm slidably sleeves the shaft sleeve.

With the technical means described above, it is possible to facilitate the sliding of the connecting arm along the sliding sleeve, so as to facilitate the sliding of the connecting shaft in the depth direction of the limiting hole.

In an embodiment, an end of the shaft sleeve proximal to the connecting seat protrudes from a surface of the connecting arm proximal to the connecting seat; and/or,

an end of the shaft sleeve distal to the connecting seat protrudes from a surface of the connecting arm distal to the connecting seat.

With the technical means described above, it is possible to prevent the connecting shaft and the case from coming into contact with the surface of the connecting arm, which otherwise impedes the rotation of the connecting arm.

In a second aspect, the embodiments of the present application further provide an energy storage device. The energy storage device includes a case and a door mounted to the case in a hinged manner, and further includes the limiting mechanism according to any of the above embodiments, where the connecting seat is connected to one of the door and the door, and the connecting arm is connected to the other of the door and the case.

With the limiting mechanism in the above embodiments, when the connecting seat is connected to the door and the connecting arm is connected to the case, when the door is opened, the door drives the connecting seat to swing, the connecting arm drives the connecting shaft to slide along the guide structure, and the travel through which the connecting shaft slides along the guide structure can control the opening degree of the door. When the locking position locks the connecting shaft, the positions of the connecting arm and the connecting seat remain fixed, thereby locking the opening degree of the door to facilitate the worker's operation.

The above description is only an overview of the technical solutions of the present application. To more clearly understand the technical means of the present application to enable implementation in accordance with the content of the specification and to make the above and other purposes, features, and advantages of the present application more obvious and easy to understand, the detailed description of the present application is provided below.

### BRIEF DESCRIPTION OF THE DRAWINGS

To more clearly illustrate the technical solutions in embodiments of the present application, the drawings required for illustrating the embodiments or exemplary technologies are briefly described below. Apparently, the drawings in the following description illustrate merely some embodiments of the present application, and those of ordinary skills in the art may still derive other drawings from these drawings without creative efforts.
FIG. 1 is a partial structural schematic view of an energy storage device according to some embodiments of the present application;
FIG. 2 is a partial structural schematic view of the energy storage device of FIG. 1, with a door closed;
FIG. 3 is a partial structural schematic view of the energy storage device of FIG. 1, with the door locked;
FIG. 4 is a schematic perspective view of a limiting mechanism of FIG. 2;
FIG. 5 is a side view of a limiting structure of FIG. 2;
FIG. 6 is a schematic perspective view of a limiting structure of FIG. 3; and
FIG. 7 is a front view of a connecting shaft according to an embodiment of the present application.

Reference numerals in the drawings have the following meanings:
100-limiting mechanism; 200-case; 300-door;
10-connecting seat; 11-connecting plate; 1101-guide structure; 1102-locking position; 12-first side plate; 13-second side plate; 14-fixing member; 15-fastener;
20-connecting shaft; 21-first shaft section; 22-second shaft section; 23-third shaft section; 24-positioning disc;
30-connecting arm; 31-first plate section; 32-second plate section; 33-third plate section; 34-reinforcing rib; 35-shaft sleeve; 36-rotating shaft.

### DETAILED DESCRIPTION

Embodiments of the present application are described in detail hereinafter, with examples of the embodiments illustrated in the drawings. Throughout the drawings, the same or similar reference numbers indicate the same or similar elements or elements having the same or similar functions. The embodiments described hereinafter with reference to the drawings are exemplary and are intended to explain the present application. They should not be construed as limiting the present application.

In the description of the present application, it should be understood that the orientations or positional relationships indicated by the terms "length", "width", "upper", "lower", "front", "rear", "left", "right", "vertical", "horizontal", "top", "bottom", "inner", "outer", and the like are those shown based on the drawing. These terms are only intended to facilitate the description of the present application and simplify the description rather than indicate or imply that the device or element referred to must have a specific orientation or must be constructed and operated in a specific orientation, and thus, should not be construed as limiting the present application.

In addition, the terms "first" and "second" are used for descriptive purposes only and are not to be construed as indicating or implying relative importance or to implicitly indicate the number of technical features indicated. Therefore, a feature defined with "first" or "second" may explicitly or implicitly include one or more such a feature.

In the description of the present application, "plurality of" means two or more, including two, unless otherwise explicitly and specifically defined. Correspondingly, "a plurality of groups" means two or more groups, including two groups.

In the description of the present application, unless otherwise clearly specified and defined, the terms "mount", "interconnect", "connect", "fix", and the like should be interpreted in their broad senses. For example, "connect" may be "fixedly connect", "detachably connect", or "integrally connect"; "mechanically connect" or "electrically connect"; or "directly interconnect", "indirectly interconnect through an intermediate", "communication between interiors of two elements", or "interaction between two elements". For those of ordinary skill in the art, the specific meanings of the aforementioned terms in the present application can be understood according to specific conditions.

In the description of the present application, the term "and/or" is merely a way to describe the associative relationship between associated objects, indicating that there are three possible relationships. For example, "A and/or B" may denote: the presence of A alone, the presence of both A and B, and the presence of B alone. In addition, the character "/" herein generally indicates an "or" relationship between the associated objects before and after the "/".

In the related art, an electrical cabinet includes a case and a door hinged to the case. The door needs to be opened during the worker's operation. When the opening degree of the door is excessively large, the portions, adjacent to the hinged position, of the door and the case are prone to collision. When the worker collides with the side of the door distal to the hinged position, the lever arm at the position where the worker collides with the door is much longer than the lever arm at the position where the door collides with the case, such that it is easily to damage the hinged position between the door and the case, resulting in partial deformation of the door and the case, which in turn affects the opening and closing of the door.

To this end, a limiting mechanism may be additionally mounted between the door and the case. The opening range of the door is limited by the limiting mechanism, so as to prevent the door from colliding with the case due to an excessively large opening degree, thereby protecting the hinged portion between the door and the case, and preventing the hinged portion between the door and the case from deforming. However, during the worker's operation, the worker often comes into contact with the door, causing the door to open and close within the opening range defined by the limiting mechanism, which interferes with the worker.

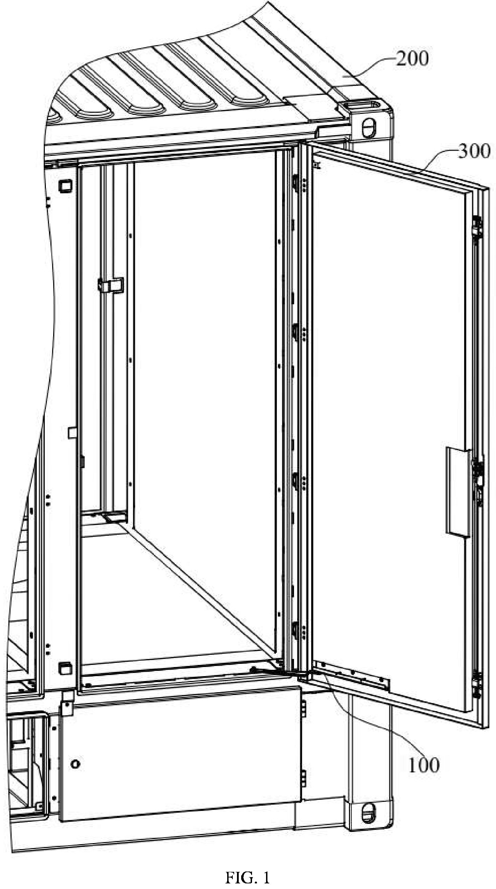

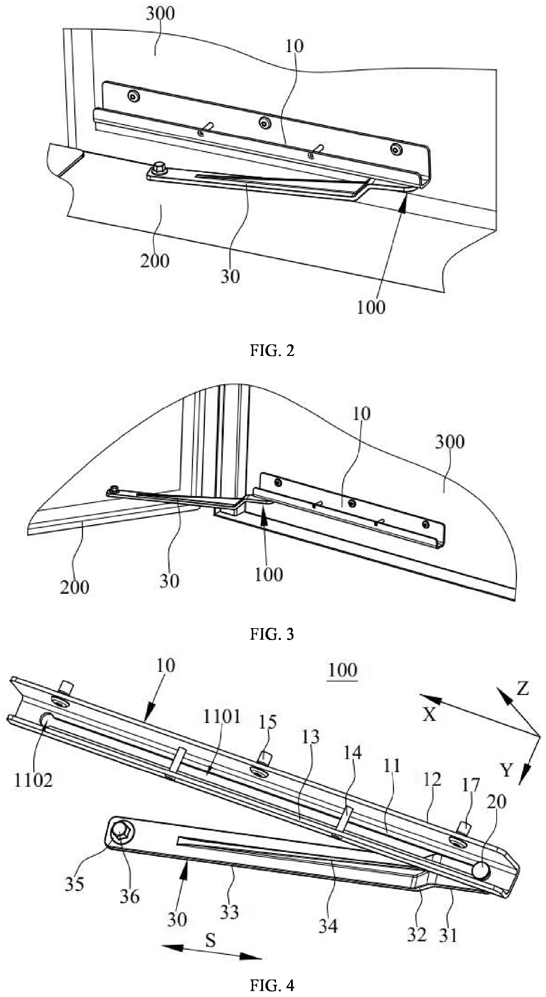

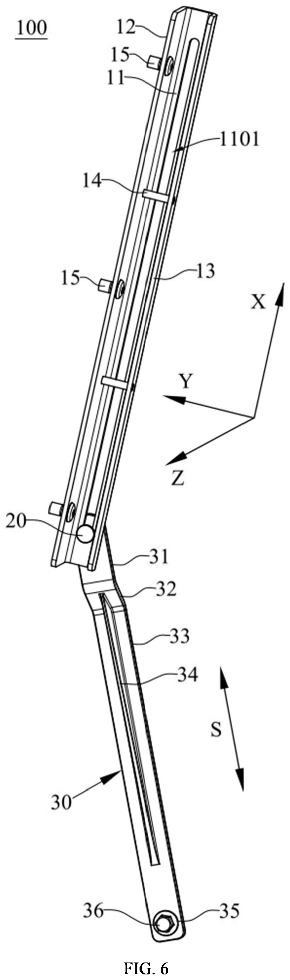

In view of the above considerations, some embodiments of the present application provide a limiting mechanism. Referring to FIGs. 1 to 6, the limiting mechanism 100 includes a connecting seat 10, a connecting shaft 20, and a connecting arm 30, where the connecting seat 10 is provided with a guide structure 1101 and a locking position 1102, and the connecting shaft 20 is in sliding fit with the guide structure 1101. The locking position 1102 is configured to lock a position of the connecting shaft 20 in a length direction X of the connecting seat 10 when the connecting arm 30 is deployed (the state as shown in FIGs. 3 and 6). The connecting seat 10 may be connected to the door 300, and the connecting arm 30 may be connected to the case 200. Therefore, when the door 300 is opened, the connecting seat 10 swings outwardly therewith, the connecting arm 30 pulls the connecting shaft 20 to slide along the guide structure 1101, and the maximum angle at which the connecting arm 30 is deployed may be limited by means of the length of the guide structure 1101, thereby limiting the opening degree of the door 300. When the connecting shaft 20 slides to the locking position 1102 (the position as shown in FIGs. 2 and 4), the locking position 1102 locks the position of the connecting shaft 20, and limits the sliding of the connecting shaft 20 in the length direction X of the connecting seat 10, thereby locking the angle between the connecting arm 30 and the connecting seat 10. In this case, the opening degree of the door 300 can be kept stable, preventing the door 300 from changing the opening degree after a collision, so as to facilitate the worker's operation.

In the following embodiments, for ease of description, a limiting mechanism 100 of an embodiment of the present application is used for illustration.

Referring to FIGs. 1 to 6, the present application provides a limiting mechanism 100. The limiting mechanism 100 includes a connecting seat 10, a connecting shaft 20, and a connecting arm 30, where the connecting seat 10 is provided with a guide structure 1101, and the guide structure 1101 is arranged in a length direction X of the connecting seat 10; the connecting shaft 20 is in sliding fit with the guide structure 1101; the connecting arm 30 is connected to the connecting shaft 20; and the connecting seat 10 is further provided with a locking position 1102, and the locking position 1102 is configured for locking the position of the connecting shaft 20 in the length direction X of the connecting seat 10.

It should be noted that the guide structure 1101 may be a structure such as a sliding bar, a sliding rail, a sliding groove, or a strip-shaped hole. When the guide structure 1101 is a sliding bar, the connecting shaft 20 may be slidably connected to the slide bar through a sliding sleeve. When the guide structure 1101 is a sliding rail, the connecting shaft 20 may be slidably connected to the slide rail through a sliding block. When the guide structure 1101 is a sliding groove or strip-shaped hole, the connecting shaft 20 may be slidably inserted in the sliding groove or strip-shaped hole, or the connecting shaft 20 may be in sliding fit with the sliding groove or the strip-shaped hole through a sliding block.

The locking position 1102 may be a catching position adapted to the connecting shaft 20. When the connecting shaft 20 is slidably connected to the connecting seat 10 through a sliding block, the locking position 1102 may also be a catching position in snap fit with the sliding block. For example, a slot is formed in the sliding block, and the locking position 1102 is a pawl or ball spring that fits and engages into the slot. One or more locking positions 1102 may be provided. When a plurality of locking positions 1102 are provided, the plurality of locking positions 1102 may be arranged in the length direction X of the connecting seat 10, such that the connecting arm 30 can be controlled to be locked at positions with different angles of deployment.

It may be that the connecting seat 10 is connected to the door 300 and the connecting arm 30 is connected to the case 200, or that the connecting seat 10 is connected to the case 200 and the connecting arm 30 is connected to the door 300. For example, when the connecting seat 10 is fixed to the case 200, an end of the connecting arm 30 distal to the connecting shaft 20 is hinged to the door 300; when the connecting arm 30 is fixed to the door 300, the connecting seat 10 is hinged to the case 200. When the door 300 is closed, the connecting shaft 20 is at an end of the guide structure 1101. During the opening of the door 300, the connecting shaft 20 slides along the guide structure 1101, the connecting arm 30 swings outwardly relative to the connecting seat 10, and the connecting arm 30 is gradually deployed from the connecting seat 10 and matches the opening degree of the door 300. Upon the connecting shaft 20 reaching the locking position 1102, the locking position 1102 can limit the sliding of the connecting shaft 20 along the guide structure 1101.

With the connecting shaft 20 in sliding fit with the guide structure 1101, when the connecting arm 30 is deployed from the connecting seat 10, the connecting shaft 20 can slide along the guide structure 1101 to adapt to the angle of deployment of the connecting arm 30 relative to the connecting seat 10. When the connecting shaft 20 slides to the locking position 1102 (the position as shown in FIG. 6), the locking position 1102 can lock the position of the connecting shaft 20, such that the position of the connecting shaft 20 in the length direction X of the connecting seat 10 is kept stable, and the angle of deployment of the connecting arm 30 relative to the connecting seat 10 is locked. In this way, when the connecting seat 10 is fixed to the door 300 and the connecting arm 30 is connected to the case 200, the limiting mechanism 100 can limit the opening range of the door 300; when the connecting shaft 20 is limited at the locking position 1102, the limiting mechanism 100 can locks the opening degree of the door 300 to prevent the movement of the door 300 from interfering with the worker's operation.

In an embodiment, referring to FIGs. 1, 4, and 6, the guide structure 1101 is a strip-shaped hole.

The connecting shaft 20 may be fixed to the connecting arm 30 or rotatably mounted to the connecting arm 30. The connecting shaft 20 is slidably inserted in the strip-shaped hole. When the angle of the connecting arm 30 relative to the connecting seat 10 changes, the connecting shaft 20 can rotate relative to the connecting arm 30 or the connecting seat 10 while sliding along the strip-shaped hole, so as to avoid interference with the deployment of the connecting arm 30.

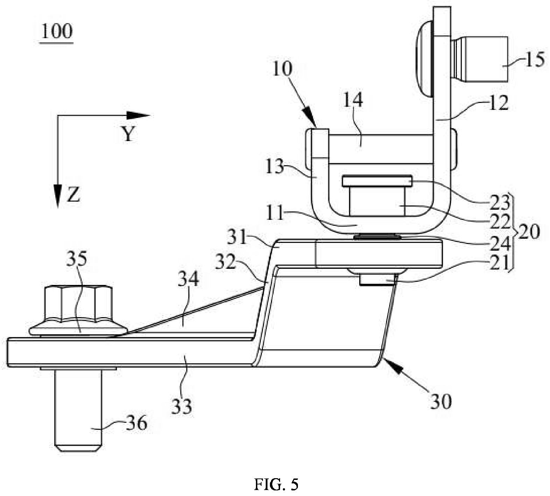

With the strip-shaped hole, the connecting shaft 20 can be guided to slide in the length direction X of the connecting seat 10, and the connecting shaft 20 can be allowed to rotate in the strip-shaped hole, so as to automatically adapt to changes in the angle of deployment of the connecting arm 30 relative to the connecting seat 10. The limiting mechanism 100 features a small number of parts and a simple structure, and is easy to machine and assemble, which facilitates reducing the dimension occupied in the depth direction (the Z-axis direction as shown in FIG. 5) of the strip-shaped hole.

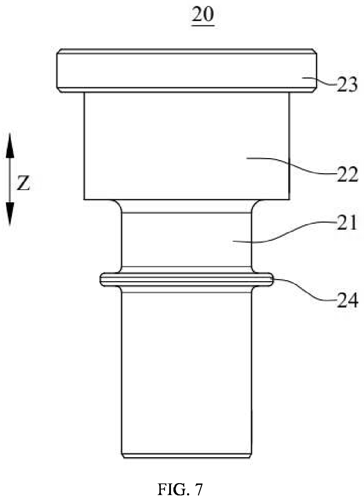

In an embodiment, referring to FIGs. 1, 4, and 6, the locking position 1102 is a limiting hole in communication with the strip-shaped hole, and the diameter of the limiting hole is greater than the width of the strip-shaped hole. Referring to FIG. 7, the connecting shaft 20 includes a first shaft section 21 and a second shaft section 22; the second shaft section 22 is connected to the first shaft section 21, the first shaft section 21 is in sliding fit with the strip-shaped hole, and the second shaft section 22 is adapted to the limiting hole to lock the connecting shaft 20.

The limiting hole may be a circular hole, a rectangular hole, or a regular polygonal hole, and the diameter of the limiting hole may be understood as the diameter of the inscribed circle of the limiting hole. Since the diameter of the limiting hole is greater than the width of the strip-shaped hole and the limiting hole is in communication with the strip-shaped hole, the first shaft section 21 can slide into the limiting hole when the first shaft section 21 slides along the strip-shaped hole.

The second shaft section 22 being adapted to the limiting hole means that the diameter of the second shaft section 22 is greater than the width of the strip-shaped hole and the diameter of the second shaft section 22 is less than the diameter of the limiting hole; the second shaft section 22 may, but is not limited to, be arranged coaxially with the first shaft section 21. When the first shaft section 21 is in the strip-shaped hole, the second shaft section 22 cannot move into the strip-shaped hole in the depth direction of the strip-shaped hole. However, when the first shaft section 21 is in the limiting hole, the second shaft section 22 can slide into the limiting hole in the depth direction of the limiting hole. When the second shaft section 22 enters the limiting hole, since the diameter of the second shaft section 22 is greater than the width of the strip-shaped hole, the second shaft section 22 cannot slide into the strip-shaped hole in the length direction of the strip-shaped hole, such that the angle between the connecting arm 30 and the connecting seat 10 is locked. After the connecting shaft 20 returns, the second shaft section 22 exits the limiting hole, the first shaft section 21 enters the limiting hole, and the first shaft section 21 can slide into the strip-shaped hole again to allow the connecting shaft 20 to slide along the guide structure 1101, thereby adjusting the angle of deployment of the connecting arm 30 relative to the connecting seat 10. The depth direction of the strip-shaped hole, the depth direction of the limiting hole, and the axial direction of the connecting shaft 20 may be the same as a height direction Z of the connecting seat 10.

The limiting hole fits with and limits the second shaft section 22, such that the structure of the locking position 1102 can be simplified, and the position of the connecting shaft 20 in the length direction X of the connecting seat 10 can be locked and unlocked simply by the movement of the connecting shaft 20 in the depth direction of the limiting hole. As a result, the unlocking and locking of the opening position of the connecting arm 30 become relatively convenient, and the machining of the connecting seat 10 is facilitated.

In an embodiment, referring to FIGs. 4 to 7, a third shaft section 23 is provided at an end of the second shaft section 22 distal to the first shaft section 21, and the diameter of the third shaft section 23 is greater than the diameter of the limiting hole.

The third shaft section 23 may be of cylindrical, prismatic, hemispherical, or other structures, but is not limited thereto. When the cross section of the third shaft section 23 is non-circular, the diameter of the third shaft section 23 refers to the diameter of the circumscribed circle of the cross section of the third shaft section 23, and the third shaft section 23 may, but is not limited to, be arranged coaxially with the second shaft section 22.

The connecting arm 30 may be connected to an end of the first shaft section 21 distal to the second shaft section 22, or the connecting arm 30 may be connected to an end of the third shaft section 23 or the second shaft section 22 distal to the first shaft section 21; a limiting cap is provided at the end of the first shaft section 21 distal to the second shaft section 22 to restrict the end of the first shaft section 21 distal to the second shaft section 22 from sliding out of the limiting hole or the strip-shaped hole in the depth direction of the strip-shaped hole.

With the third shaft section 23, when the connecting shaft 20 slides until the second shaft section 22 is limited in the limiting hole, since the diameter of the third shaft section 23 is greater than the diameter of the limiting hole, it is possible to prevent the connecting shaft 20 from sliding out of the limiting hole from the end of the second shaft section 22 distal to the first shaft section 21, thereby preventing the connecting shaft 20 from being separated from the connecting seat 10.

In an embodiment, referring to FIGs. 4 to 7, the end of the first shaft section 21 distal to the second shaft section 22 is connected to the connecting arm 30.

The connecting arm 30 may be welded or rotatably connected to the first shaft section 21. When the connecting arm 30 is rotatably connected to the first shaft section 21, the first shaft section 21 may be provided with a limiting ring to limit the sliding of the connecting arm 30 in the axial direction on the first shaft section 21.

Referring to FIG. 5, the end of the first shaft section 21 distal to the second shaft section 22 is connected to the connecting arm 30, such that the connecting arm 30 can limit the upward movement of the connecting shaft 20, i.e., limiting the movement of the connecting shaft 20 toward a side of the connecting seat 10 distal to the connecting arm 30, and the connecting shaft 20 can be prevented from sliding out of the limiting hole or strip-shaped hole from the end of the first shaft section 21 distal to the second shaft section 22, thereby preventing the connecting shaft 20 from being separated from the connecting seat 10.

In an embodiment, referring to FIGs. 4 to 7, a positioning disc 24 is provided in the middle of the first shaft section 21 in the axial direction (Z-axis direction in FIG. 7). The positioning disc 24 is configured for stopping and positioning the connecting arm 30; the connecting arm 30 sleeves the first shaft section 21, and the connecting arm 30 is located on a side of the positioning disc 24 distal to the second shaft section 22.

The positioning disc 24 may, but is not limited to, be formed integrally with the first shaft section 21, and the positioning disc 24 may be in circular, square, or other shapes, as long as the area thereof is greater than the cross-sectional area of the first shaft section 21. The axial direction of the first shaft section 21 is the same as the depth direction of the limiting hole.

The connecting arm 30 is provided with a first through hole at a position corresponding to the first shaft section 21, the first shaft section 21 is inserted into the first through hole in a fitting manner, and the area of the positioning disc 24 is greater than the cross-sectional area of the first through hole, so as to stop the connecting arm 30 and restrict the connecting arm 30 from sliding toward the end of the first shaft section 21 proximal to the second shaft section 22. After the first shaft section 21 is inserted into the first through hole, the first shaft section 21 may be fixed to the connecting arm 30 by welding, but the method is not limited to welding.

By stopping the connecting arm 30 by the positioning disc 24, it is possible to position the position of the connecting arm 30 on the first shaft section 21, so as to control the distance between the connecting arm 30 and the third shaft section 23 and limit the extent to which the connecting shaft 20 slides in the depth direction of the strip-shaped hole.

In an embodiment, referring to FIGs. 4 to 7, the connecting seat 10 includes a connecting plate 11, a first side plate 12, and a second side plate 13. The first side plate 12 is disposed on a side of the connecting plate 11 in the width direction (the Y-axis direction as shown in FIG. 5), the second side plate 13 is disposed on the other side of the connecting plate 11 in the width direction, and the first side plate 12 and the second side plate 13 are located on a side of the connecting plate 11 in the thickness direction (the Z-axis direction as shown in FIG. 5); the guide structure 1101 and the locking position 1102 are disposed on the connecting plate 11.

The first side plate 12 and the second side plate 13 may, but are not limited to, be formed by bending the side edges of the connecting plate 11, such that the machining of the connecting seat 10 can be facilitated by using a whole plate for bending. The cross section of the connecting seat 10 may be U-shaped, and the strip-shaped hole may be located in the middle of the connecting plate 11 in the width direction.

By providing the first side plate 12 and the second side plate 13 at the side edges of the connecting plate 11, the anti-bending strength of the connecting seat 10 can be enhanced to prevent the connecting seat 10 from bending and deforming.

In an embodiment, referring to FIGs. 4 to 7, the connecting seat 10 further includes fixing members 14, where the fixing members 14 connect the first side plate 12 and the second side plate 13.

The fixing member 14 may be a plate, a screw, a riveted part, a pin shaft, or the like, and the fixing member 14 may be connected and fixed to the first side plate 12 or the second side plate 13 by using methods such as threaded connection, riveting, or welding.

Optionally, the fixing member 14 is a pin shaft. Second through holes are formed in the first side plate 12, third through holes are formed in the second side plate 13 at positions directly opposite the second through holes, and both ends of each fixing member 14 are inserted into the second through hole and the third through hole, respectively. The fixing member 14 may be welded to the first side plate 12 and the second side plate 13 by a plug welding process, and both ends of the pin shaft are flattened after welding, which contributes to improving the appearance quality.

The fixing member 14 is connected to the first side plate 12 and the second side plate 13, such that the distance between the first side plate 12 and the second side plate 13 can be kept stable, thereby enhancing the stability of the first side plate 12 and the second side plate 13.

In an embodiment, referring to FIGs. 4 to 7, a plurality of fixing members 14 are provided, and the plurality of fixing members 14 are arranged in the length direction of the connecting plate 11 (the X-axis direction as shown in FIG. 4).

The structures of the plurality of fixing members 14 may all be pin shafts, and the assembly can be facilitated by using the same fixing members 14. The plurality of fixing members 14 may, but are not limited to, be arranged at equal spacings. With an equally spaced arrangement, the connection positions between the first side plate 12 and the second side plate 13 can be distributed evenly. Certainly, in other embodiments, the plurality of fixing members 14 may be of different structures, for example, some of the fixing members 14 are plates and some of the fixing members 14 are pin shafts.

The use of the plurality of fixing members 14 can improve the stability of the connection between the first side plate 12 and enhance the second side plate 13, and the structural strength of the connecting seat 10.

In an embodiment, referring to FIGs. 2 to 5, fasteners 15 are mounted on the first side plate 12 for connection to the door 300.

The fasteners 15 may be rivets, bolts, pin shafts, or the like. A plurality of fasteners 15 may be provided, and the plurality of fasteners 15 may be arranged in the length direction of the first side plate 12, such that it is condutive to improving the stability of connection parts when the first side plate 12 is connected to the case 200.

With the fasteners 15, the first side plate 12 can be connected and fixed to the door 300, and the connecting seat 10 can be mounted to the door 300.

In an embodiment, referring to FIGs. 4 to 7, the connecting arm 30 is located on the other side of the connecting plate 11 in the thickness direction.

That is, the connecting arm 30 is located on the side of the connecting plate 11 distal to the first side plate 12 and the second side plate 13. Specifically, the third shaft section 23 is located at an end of the connecting shaft 20 proximal to the first side plate 12 and the second side plate 13, and the first shaft section 21 is located at an end of the connecting shaft 20 distal to the first side plate 12 and the second side plate 13.

The arrangement of the connecting arm 30 on the side of the connecting plate 11 distal to the first side plate 12 and the second side plates 13 enables to avoid the first side plate 12 and the second side plate 13 interfering with the movement of the connecting arm 30, and is condutive to reducing the spacing between the connecting arm 30 and the connecting plate 11 and the length of the connecting shaft 20, and improving the stability between the connecting arm 30 and the connecting seat 10.

In an embodiment, referring to FIGs. 4 to 7, the connecting arm 30 is provided with a reinforcing rib 34, where the reinforcing rib 34 is arranged in a length direction S of the connecting arm 30.

The reinforcing rib 34 may, but is not limited to, be located in the middle of the connecting arm 30 in the width direction; the number of reinforcing ribs 34 may be one or more, and in the case of a plurality of reinforcing ribs 34, the reinforcing ribs 34 may be separately disposed on opposite sides of the connecting arm 30. The width direction of the connecting arm 30 may be perpendicular to the axial direction of the connecting shaft 20 and the length direction S of the connecting arm 30.

The arrangement of the reinforcing ribs 34 enables to enhance the anti-bending strength of the connecting arm 30, thereby preventing the connecting arm 30 from bending and deforming, which otherwise affects the opening and closing of the door 300.

In an embodiment, referring to FIGs. 4 to 7, the connecting arm 30 includes a first plate section 31, a second plate section 32, and a third plate section 33, where the first plate section 31 is connected to the connecting shaft 20, the second plate section 32 is connected to an end of the first plate section 31 distal to the connecting shaft 20, the third plate section 33 is connected to an end of the second plate section 32 distal to the first plate section 31, and the second plate section 32 is inclined toward a direction away from the connecting seat 10 from the end of the first plate section 31 distal to the connecting shaft 20 to an end of the third plate section 33 proximal to the connecting shaft 20.

The first plate section 31 may be perpendicular to the connecting shaft 20, and the length direction of the third plate section 33 may be parallel to the length direction of the first plate section 31 (the S direction as shown in FIG. 4); the length of the first plate section 31 may be less than the length of the second plate section 32, and the length of the first plate section 31 may be less than the length of the third plate section 33. The second plate section 32 is inclined toward a direction away from the connecting plate 11 from the end of the first plate section 31 distal to the connecting shaft 20 to the end of the third plate section 33 proximal to the connecting shaft 20, that is, when the first plate section 31 is parallel to the connecting plate 11, the distance between the end of the second plate section 32 distal to the first plate section 31 and the connecting plate 11 (in the axial direction of the connecting shaft 20) is greater than the distance between the end of the second plate section 32 proximal to the first plate section 31 and the connecting plate 11, such that the transition between the second plate section 32 and the first plate section 31 and the third plate section 33 is smooth, and the third plate section 33 is more distal to the connecting plate 11 than the first plate section 31.

With the first plate section 31, the second plate section 32, and the third plate section 33, when the connecting arm 30 is folded to the side edge of the connecting seat 10 (the position as shown in FIGs. 2 and 4), the distances between the second plate section 32 and the third plate section 33 and the connecting seat 10 are relatively large, which contributes to avoiding friction between the end of the connecting arm 30 distal to the connecting shaft 20 and the connecting seat 10.

In an embodiment, referring to FIGs. 4 to 7, the reinforcing rib 34 is located on a side of the third plate section 33 proximal to the connecting seat 10, and the reinforcing rib 34 is connected to the second plate section 32 and the third plate section 33.

The height of the reinforcing rib 34 may gradually decrease from an end proximal to the first plate section 31 to an end distal to the first plate section 31, so as to reduce friction between the reinforcing rib 34 and the connecting plate 11.

The second plate section 32 is connected to the third plate section 33 by the reinforcing rib 34, such that the structural strength of the second plate section 32 and the third plate section 33 can be increased, thereby preventing the second plate section 32 and the third plate section 33 from bending and deforming, and the angle between the third plate section 33 and the second plate section 32 can be kept stable.

In an embodiment, referring to FIGs. 4 to 7, each side surface of the reinforcing rib 34 in the width direction is inclined toward a direction close to the middle of the reinforcing rib 34 in the width direction from a side of the reinforcing rib 34 proximal to the third plate section 33 to a side of the reinforcing rib 34 distal to the third plate section 33. The width direction of the reinforcing rib 34 is the same as the width direction of the third plate section 33.

Referring to FIG. 6, the side surfaces of the reinforcing rib 34 in the width direction refer to the left and right side surfaces of the reinforcing rib 34, the side surfaces of the reinforcing rib 34 in the width direction are inclined toward the middle of the reinforcing rib 34 in the width direction from the third plate section 33 toward a direction away from the third plate section 33, and the width of the reinforcing rib 34 gradually decreases from the side proximal to the third plate section 33 to the side distal to the third plate section 33. Optionally, the included angles between the side surfaces of the reinforcing rib 34 in the width direction and the height direction of the reinforcing rib 34 may range from 1° to 30°, for example, 5°, 10°, or 15°. The included angles between two side surfaces of the reinforcing rib 34 in the width direction and the height direction of the reinforcing rib 34 may be equal. The height direction of the reinforcing rib 34 is the same as the thickness direction of the third plate section 33.

A certain draft angle is formed by inclining the two side surfaces of the reinforcing rib 34 in the width direction, which facilitates demolding during casting.

In an embodiment, referring to FIGs. 4 to 7, a rotating shaft 36 is mounted at an end of the connecting arm 30 distal to the connecting shaft 20, and the rotating shaft 36 is configured to be hinged to the case 200.

That is, an end of the third plate section 33 distal to the first plate section 31 is hinged to the case 200 through the rotating shaft 36, and the rotating shaft 36 may rotate relative to the third plate section 33 or the case 200.

With the rotating shaft 36, the connecting arm 30 can be hinged to the case 200, such that when the door 300 rotates, the connecting arm 30 can rotate relative to the case 200 to adapt to the opening degree of the door 300.

In an embodiment, referring to FIGs. 4 to 7, a shaft sleeve 35 sleeves the rotating shaft 36, and the connecting arm 30 slidably sleeves the shaft sleeve 35.

A fourth through hole is formed in an end of the third plate section 33 distal to the connecting shaft 20, and the shaft sleeve 35 is slidably inserted into the fourth through hole. As the connecting shaft 20 moves in the Z-axis direction, the third plate section 33 can slide along the shaft sleeve 35 to keep the heights of the connecting arm 30 and the connecting shaft 20 matching.

The rotating shaft 36 may be a screw or a pin shaft, the upper end surface of the shaft sleeve 35 is higher than the upper surface of the third plate section 33, such that when the rotating shaft 36 is connected to the case 200, the rotating shaft 36 will not press against the third plate section 33.

The shaft sleeve 35 is slidably connected to the connecting arm 30, which can facilitate the sliding of the connecting arm 30 along the shaft sleeve 35, so as to facilitate the sliding of the connecting shaft 20 in the depth direction of the limiting hole.

In an embodiment, referring to FIGs. 4 to 7, an end of the shaft sleeve 35 proximal to the connecting seat 10 protrudes from a surface of the connecting arm 30 proximal to the connecting seat 10; and/or, an end of the shaft sleeve 35 distal to the connecting seat 10 protrudes from a surface of the connecting arm 30 distal to the connecting seat 10.

Referring to FIG. 5, the end of the shaft sleeve 35 proximal to the connecting seat 10 is the upper end of the shaft sleeve 35, and the upper end of the shaft sleeve 35 is higher than the upper surface of the third plate section 33. The end of the shaft sleeve 35 distal to the connecting seat 10 is the lower end of the shaft sleeve 35, and the lower end of the shaft sleeve 35 is lower than the lower surface of the third plate section 33.

A mounting hole is formed in the third plate section 33, the shaft sleeve 35 is provided in the mounting hole in a penetrating manner, and two ends of the shaft sleeve 35 each extend out of the mounting hole. Two ends of the shaft sleeve 35 extending out of the mounting hole may be provided with flanges to facilitate fixing the shaft sleeve 35 to the third plate section 33, thereby restricting the shaft sleeve 35 from falling out of the mounting hole.

The upper end of the shaft sleeve 35 protruding from the upper surface of the connecting seat 10 enables to prevent the upper surface of the third plate section 33 from coming into contact with the rotating shaft 36, which otherwise impedes the rotation of the connecting arm 30. The lower end of the shaft sleeve 35 protruding from the lower surface of the connecting seat 10 enables to prevent the lower surface of the third plate section 33 from coming into contact with the case 200, which otherwise impedes the rotation of the connecting arm 30.

In a second aspect, referring to FIGs. 1 to 3, the embodiments of the present application further provide an energy storage device. The energy storage device includes a case 200 and a door 300 mounted to the case 200 in a hinged manner, and further includes the limiting mechanism 100 according to any of the above embodiments, where the connecting seat 10 is connected to the door 300, and the connecting arm 30 is connected to the case 200. Alternatively, the connecting seat 10 is connected to the case 200, and the connecting arm 30 is connected to the door 300.

The energy storage device may be, but is not limited to, an electrical cabinet, an energy storage container, etc. One or more batteries or the like may be mounted within the case 200. When a plurality of batteries are present within the case 200, the plurality of batteries may be connected in series, in parallel, or in series-parallel.

Referring to FIGs. 4 and 6 together, the locking position 1102 is located at an end of the strip-shaped hole proximal to the hinged portion of the door 300, and when the door 300 is closed, the connecting shaft 20 is located at an end of the strip-shaped hole distal to the hinged portion of the door 300. When the connecting seat 10 is connected to the door 300 and the connecting arm 30 is connected to the case 200, the connecting seat 10 swings outwardly along with the door 300 when the door 300 is opened, and the connecting shaft 20 slides toward the hinged portion of the door 300. When the connecting shaft 20 slides into the limiting hole, the second shaft section 22 falls into the limiting hole, the limiting hole fits with the second shaft section 22 to lock the position of the connecting shaft 20, thereby locking the opening degree of the door 300 relative to the case 200. When the connecting seat 10 is connected to the case 300 and the connecting arm 30 is connected to the door 200, the connecting arm 30 swings outwardly along with the door 300 when the door 300 is opened, and the connecting shaft 20 slides toward the hinged portion of the case 200. When the connecting shaft 20 slides into the limiting hole, the second shaft section 22 falls into the limiting hole, the limiting hole fits with the second shaft section 22 to lock the position of the connecting shaft 20, thereby locking the opening degree of the door 300 relative to the case 200.

With the limiting mechanism 100 according to the above embodiments, when the door 300 is opened, the door 300 drives the connecting seat 10 to swing, the connecting arm 30 drives the connecting shaft 20 to slide along the guide structure 1101, and the travel through which the connecting shaft 20 slides along the guide structure 1101 can control the opening degree of the door 300. When the locking position 1102 locks the connecting shaft 20, the positions of the connecting arm 30 and the connecting seat 10 remain fixed, thereby locking the opening degree of the door 300 to facilitate the worker's operation.

Referring to FIGs. 1 to 7, the embodiments of the present application provide an energy storage device. The energy storage device includes a case 200, a door 300, and a limiting mechanism 100. A connecting seat 10 is riveted to the door 300, a connecting arm 30 is hinged to the case 200, and the connecting arm 30 is located under the connecting seat 10. When the door 300 is closed, a connecting shaft 20 slides to an end of a strip-shaped hole distal to a limiting hole. When the door 300 is opened, the connecting shaft 20 gradually slides to the limiting hole. After a first shaft section 21 of the connecting shaft 20 slides into the limiting hole, the connecting arm 30 and the connecting shaft 20 fall under the action of gravity of the connecting arm 30 and the connecting shaft 20, a second shaft section 22 slides into the limiting hole, and the limiting hole locks the position of the connecting shaft 20, thereby locking the opening degree of the door 300. When the door 300 needs to be closed, the connecting arm 30 is pulled upward; the connecting arm 30 drives the connecting shaft 20 to move upward, and the first shaft section 21 enters the limiting hole. In this case, by pushing the door 300, the first shaft section 21 slides into the strip-shaped hole and slides along the strip-shaped hole, thereby closing the door 300.

The foregoing description is merely illustrative of the optional embodiments of the present application, and is not intended to limit the present application. Various changes and variations may be made to the present application for a person skilled in the art. Any modification, equivalent substitution, improvement, and the like made within the spirit and principle of the present application shall all fall within the scope of the claims of the present application.

## Claims

1. A limiting mechanism (100), comprising:
a connecting seat (10), wherein the connecting seat (10) is provided with a guide structure (1101), and the guide structure (1101) is arranged in a length direction of the connecting seat (10);
a connecting shaft (20) in sliding fit with the guide structure (1101); and
a connecting arm (30) connected to the connecting shaft (20), wherein
the connecting seat (10) is further provided with a locking position (1102) for locking a position of the connecting shaft (20) in the length direction of the connecting seat (10).

2. The limiting mechanism (100) according to claim 1, wherein the guide structure (1101) is a strip-shaped hole.

3. The limiting mechanism (100) according to claim 2, wherein the locking position (1102) is a limiting hole in communication with the strip-shaped hole, a diameter of the limiting hole being greater than a width of the strip-shaped hole; and
the connecting shaft (20) comprises a first shaft section (21) in sliding fit with the strip-shaped hole and a second shaft section (22) connected to the first shaft section (21), the second shaft section (22) being adapted to the limiting hole.

4. The limiting mechanism (100) according to claim 3, wherein a third shaft section (23) is provided at an end of the second shaft section (22) distal to the first shaft section (21), a diameter of the third shaft section (23) being greater than the diameter of the limiting hole.

5. The limiting mechanism (100) according to claim 3 or 4, wherein an end of the first shaft section (21) distal to the second shaft section (22) is connected to the connecting arm (30).

6. The limiting mechanism (100) according to claim 5, wherein a positioning disc (24) for stopping and positioning the connecting arm (30) is provided in a middle of the first shaft section (21) in an axial direction, the connecting arm (30) sleeves the first shaft section (21), and the connecting arm (30) is located on a side of the positioning disc (24) distal to the second shaft section (22).

7. The limiting mechanism (100) according to any one of claims 1 to 6, wherein the connecting seat (10) comprises a connecting plate (11), a first side plate (12) disposed on a side of the connecting plate (11) in a width direction, and a second side plate (13) disposed on the other side of the connecting plate (11) in the width direction, wherein the first side plate (12) and the second side plate (13) are located on a side of the connecting plate (11) in a thickness direction, and the guide structure (1101) and the locking position (1102) are disposed on the connecting plate (11).

8. The limiting mechanism (100) according to claim 7, wherein the connecting seat (10) further comprises fixing members (14) connecting the first side plate (12) and the second side plate (13).

9. The limiting mechanism (100) according to claim 8, wherein a plurality of said fixing members (14) are provided, and the plurality of fixing members (14) are arranged in a length direction of the connecting plate (11).

10. The limiting mechanism (100) according to claim 7 or 8, wherein fasteners (15) are mounted on the first side plate (12) for connection to a door (300).

11. The limiting mechanism (100) according to any one of claims 7 to 10, wherein the connecting arm (30) is located on the other side of the connecting plate (11) in the thickness direction.

12. The limiting mechanism (100) according to any one of claims 1 to 11, wherein the connecting arm (30) is provided with a reinforcing rib (34), and the reinforcing rib (34) is arranged in a length direction of the connecting arm (30).

13. The limiting mechanism (100) according to claim 12, wherein the connecting arm (30) comprises a first plate section (31) connected to the connecting shaft (20), a second plate section (32) connected to an end of the first plate section (31) distal to the connecting shaft (20), and a third plate section (33) connected to an end of the second plate section (32) distal to the first plate section (31), wherein the second plate section (32) is obliquely arranged toward a direction away from the connecting seat (10) from the end of the first plate section (31) distal to the connecting shaft (20) to an end of the third plate section (33) proximal to the connecting shaft (20).

14. The limiting mechanism (100) according to claim 13, wherein the reinforcing rib (34) is located on a side of the third plate section (33) proximal to the connecting seat (20), and the reinforcing rib (34) is connected to the second plate section (32) and the third plate section (33).

15. The limiting mechanism (100) according to claim 14, wherein a height of the reinforcing rib (34) gradually decreases from an end of the second plate section (32) proximal to the first plate section (31) to an end of the third plate section (33) distal to the first plate section (31).

16. The limiting mechanism (100) according to claim 14 or 15, wherein each side surface of the reinforcing rib (34) in a width direction is inclined toward a direction close to a middle of the reinforcing rib (34) in the width direction from a side of the reinforcing rib (34) proximal to the third plate section (33) to a side of the reinforcing rib (34) distal to the third plate section (33).

17. The limiting mechanism (100) according to any one of claims 1 to 16, wherein a rotating shaft (36) for being hinged to a case (200) is mounted at an end of the connecting arm (30) distal to the connecting shaft (20).

18. The limiting mechanism (100) according to claim 17, wherein a shaft sleeve (35) sleeves the rotating shaft (36), and the connecting arm (30) slidably sleeves the shaft sleeve (35).

19. The limiting mechanism (100) according to claim 18, wherein an end of the shaft sleeve (35) proximal to the connecting seat (20) protrudes from a surface of the connecting arm (30) proximal to the connecting seat (10); and/or,
an end of the shaft sleeve (35) distal to the connecting seat (10) protrudes from a surface of the connecting arm (30) distal to the connecting seat (10).

20. An energy storage device, comprising a case (200) and a door (300) mounted to the case (200) in a hinged manner, and further comprising the limiting mechanism (100) according to any one of claims 1 to 19, wherein the connecting seat (10) is connected to one of the door (300) and the door (300), and the connecting arm (30) is connected to the other of the door (300) and the case (200).
